# FASCICULE DE BREVET EUROPEEN

(11) **EP 1 419 289 B1**
(45) Date de publication et mention de la délivrance du brevet: **06.07.2005**
(21) Numéro de dépôt: 02796309.9
(22) Date de dépôt: 23.08.2002
(51) Int. Cl.: C25D 5/02, C25D 5/16, C25D 7/06, H01R 4/26, H01R 13/03

(54) **DISPOSITIF DE DEPOT EN CONTINU PAR ELECTRODEPOSITION ET COMPOSANTS ELECTRIQUES OU ELECTRONIQUES FABRIQUES EN BANDE COMPORTANT UNE COUCHE DE PLACAGE PAR ELECTRODEPOSITION**
VORRICHTUNG ZUR KONTINUIERLICHEN GALVANISCHEN ABSCHEIDUNG UND ELEKTRISCHE ODER ELEKTRONISCHE BAUELEMENTE IN STREIFENFORM MIT EINER GALVANISCH ABGESCHIEDENEN SCHICHT
DEVICE FOR CONTINUOUS ELECTRODEPOSITION AND ELECTRICAL OR ELECTRONIC COMPONENTS MANUFACTURED IN STRIP COMPRISING A PLATED LAYER BY ELECTRODEPOSITION

(30) Priorité: 24.08.2001 FR 0111070
(43) Date de publication de la demande: 19.05.2004
(73) Titulaire: ITT MANUFACTURING ENTERPRISES, INC., Wilmington, Delaware 19801 (US)
(72) Inventeur: GUYOT, Jean-Louis, F-39100 Dole (FR)
(74) Mandataire: Kohn, Philippe
(86) Numéro de dépôt international: PCT/FR2002/002929
(87) Numéro de publication internationale: WO 2003/018881

(56) Documents cités:
- US-A- 3 819 502
- US-A- 4 441 975
- US-A- 5 185 073
- US-A- 5 509 200
- US-B1- 6 245 445

## Description

La présente invention concerne un dispositif pour le dépôt, ou placage, en continu par voie électrolytique, d'une couche de revêtement métallique, notamment en métal précieux, selon un tracé déterminé sur la face supérieure d'une bande métallique, du type comportant au moins un masque supérieur interposé entre l'électrolyte et la face supérieure de la bande métallique et qui est réalisé sous la forme d'au moins une courroie latérale de masquage qui défile en continu avec la bande métallique et dont les découpes correspondent au tracé à réaliser.

L'invention concerne aussi un composant électrique ou électronique fabriqué en bande et du type comportant une portion de face supérieure munie d'une couche de revêtement métallique déposée en continu par voie électrolytique, selon un tracé déterminé.

L'invention concerne ainsi d'une manière générale le placage par électrodéposition d'une couche de revêtement en métal précieux, par exemple en or ou en argent ou en alliage de ces métaux, sur une portion du composant destinée à assurer une fonction de contact électrique à laquelle on veut conférer une grande qualité et une grande fiabilité.

Afin d'économiser le métal précieux et de ne déposer qu'une couche de faible épaisseur, et selon un tracé ou motif déterminé, on a proposé d'utiliser un dispositif du type mentionné précédemment pour la mise en oeuvre du procédé « MECO » qui est par exemple décrit et représenté dans les documents US-A-3.819.502 et US-A-5 372.699 au contenu desquels on pourra se reporter pour connaître en détails ce procédé et la conception des appareils et dispositifs pour sa mise en oeuvre, et notamment la conception de la roue ou tambour à électrolyte formant anode.

Grâce à cette technique, il est possible de maîtriser le placage de métal précieux sur des composants tels que des lames de contact pour connecteurs électriques, des éléments en forme de dôme déformables élastiquement pour des commutateurs électriques à effet tactile, ou encore des semi-conducteurs ou microcircuits électroniques.

Cette technologie permet par exemple de réaliser des dépôts en continu sur des composants, agencés en bande, selon un tracé tel qu'une ligne parallèle au défilement en continu de la bande, ou selon un tracé tel qu'une ou plusieurs pastilles par composant. Ce procédé, outre la régularité du placage, est économique car il permet de ne déposer du métal précieux que sur une seule face du composant.

Selon le métal de placage utilisé et en fonction de l'application, l'épaisseur régulière de la couche de revêtement qui est déposée est par exemple comprise entre 0,2 et 2 micromètres.

On a aussi proposé dans le document US-A-4.361.470 un autre procédé de dépôt électrolytique d'une couche bimétallique à surface continue et d'épaisseur variable.

Pour économiser la quantité de métal déposé en réalisant un placage d'épaisseur variable, on a aussi proposé une solution dans le document US-A-3.915.832 qui nécessite d'agencer les composants sur un tambour et qui ne permet donc plus un traitement continu en bande. Cette solution permet néanmoins d'obtenir un placage d'épaisseur la plus forte dans une zone déterminée, cette épaisseur diminuant progressivement à partir de cette zone privilégiée dont la surface externe est lisse et continue comme dans le cas des autres solutions selon l'état de la technique.

Enfin, on a proposé dans le document US-A-6.027.631 d'utiliser des tournants agencés entre l'anode et la cathode et de créer mouvement relatif en rotation entre les écrans et les électrodes pour moduler le champ électrique de couplage et pour maîtriser ainsi l'épaisseur de la couche de placage en remédiant aux inconvénients connus de l'électrodéposition quant à la maîtrise de l'épaisseur, et notamment de la régularité de celle-ci.

Cette solution est particulièrement complexe, n'est pas adaptée au traitement en bande, et elle ne permet pas de réaliser une économie importante de métal précieux.

L'invention vise à proposer une technologie qui, pour une même épaisseur totale de la couche de placage, permette d'économiser une quantité importante de métal précieux, tout en conservant les propriétés et les qualités de la couche de revêtement.

L'invention vise aussi à améliorer la précision géométrique du dépôt.

A cet effet, l'invention propose un dispositif du type mentionné précédemment, caractérisé en ce qu'il comporte un écran intermédiaire, formant pochoir, qui est interposé entre le masque et la face supérieure de la bande métallique et qui est constitué d'un réseau maillé, ou canevas ou grille, délimitant des trous pour le passage de l'électrolyte de manière à obtenir le dépôt d'un revêtement comportant en surface une série de pics agencés selon le motif des mailles du pochoir.

Cette conception selon l'invention est particulièrement avantageuse car elle peut être mise en oeuvre avec des machines ou appareils existants à roue d'électrolyte par exemple selon la technologie "MECO", sans modifications de ces machines.

Selon d'autres caractéristiques du dispositif :
- la face inférieure de l'écran intermédiaire est en contact avec la face supérieure de la bande métallique ;
- l'écran intermédiaire est réalisé sous la forme d'un ruban qui défile en continu avec la bande métallique ;
- le ruban formant écran intermédiaire est lié en défilement avec la courroie de masquage, notamment par collage ;
- l'écran intermédiaire est réalisé par tissage ;
- le motif des mailles du pochoir est un motif à mailles carrées ;
- la section de passage du trou de chaque maille est égale à environ 25.10⁻⁴ mm², avec un pas de maillage d'environ 8,5.10⁻² mm ;
- le masque supérieur est constitué d'au moins une courroie latérale de masquage qui est fixée, et liée en défilement continu, sous la face inférieure d'un support supérieur réalisée notamment sous la forme d'une tresse comportant des ajours.

L'invention propose aussi un composant électrique ou électronique fabriqué en bande et du type comportant une portion de face supérieure munie d'une couche de revêtement métallique déposée en continu par voie électrolytique, selon un tracé déterminé, caractérisé en ce que, en surface, la couche de revêtement métallique comporte une série de pics agencés selon un motif maillé.

Ainsi, contrairement aux solutions selon l'art antérieur, la surface externe de la couche de placage présente une surface qui est volontairement discontinue, tout en conservant ses propriétés électriques et de résistance à la corrosion.

Selon d'autres caractéristiques du composant :
- les sommets des pics sont sensiblement coplanaires ;
- chaque pic est sensiblement en forme de tronc de pyramide ;
- l'épaisseur moyenne de la couche de revêtement métallique est comprise entre 60 et 70% de son épaisseur maximale mesurée à la crête des pics ;
- l'épaisseur maximale de la couche de revêtement métallique mesurée à la crête des pics est comprise entre 0,2 et 2 micromètres, notamment entre 1,4 et 2 micromètres.

D'autres caractéristiques et avantages de l'invention, apparaîtront à la lecture de la description détaillée qui va suivre pour la compréhension de laquelle on se reportera aux dessins annexés dans lesquels :
- la figure 1 est une vue schématique en coupe par un plan transversal vertical d'un dispositif pour le dépôt en continu par voie électrolytique conforme aux enseignements de l'invention pour la réalisation d'un placage sur une bande de métal ,
- la figure 2 est une vue schématique en perspective éclatée des éléments représentés à la figure 1 ;

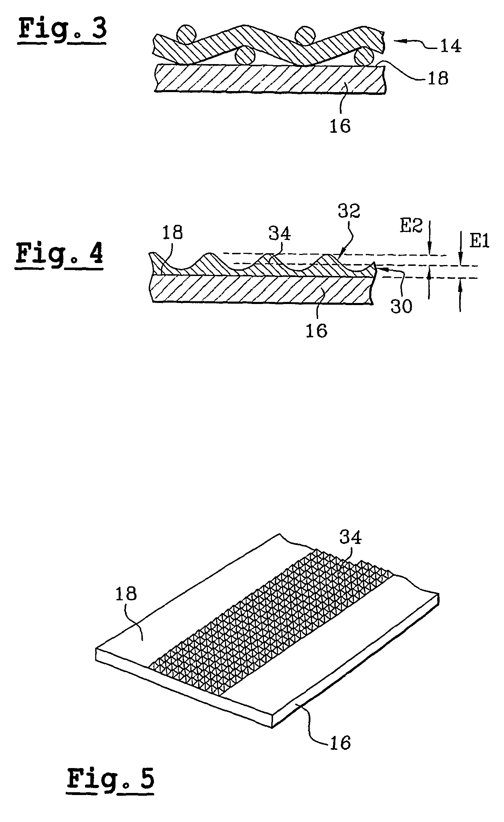

- la figure 3 est une vue à plus grande échelle qui représente, en section par un plan longitudinal vertical, le masque formant pochoir agencé au-dessus de la bande métallique à plaquer ;
- la figure 4 est une vue en coupe par un plan vertical longitudinal de la bande métallique après le dépôt de la couche de revêtement métallique grâce au dispositif selon l'invention ;
- la figure 5 est une vue schématique en perspective à très grande échelle illustrant une portion de la surface du dépôt ou placage obtenu grâce au dispositif selon l'invention.

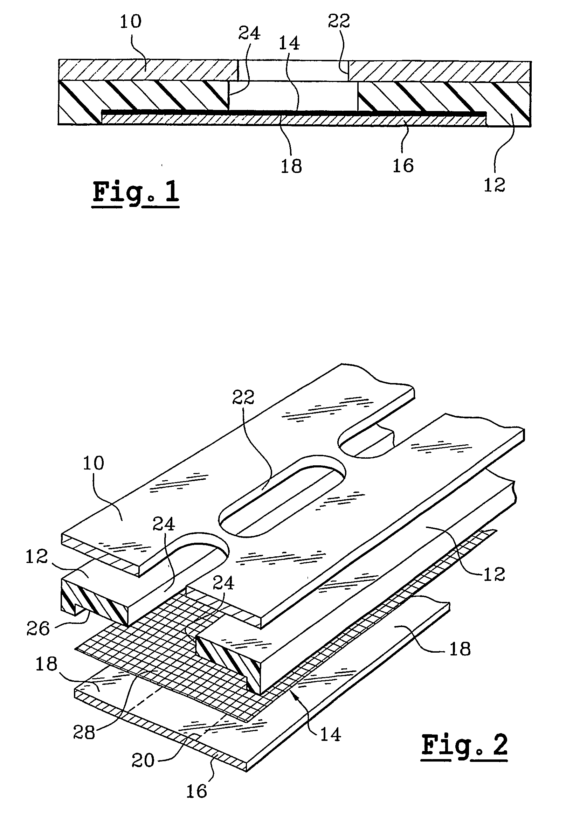

On adoptera par convention, et à titre non limitatif, une orientation verticale en considérant les figures 1 et 2, ainsi qu'une orientation longitudinale correspondant à la direction de défilement en continu du dispositif, et une orientation transversale perpendiculairement à la direction longitudinale.

L'empilage représenté aux figures 1 et 2 est constitué pour l'essentiel par un support supérieur 10, deux courroies 12 de masquage et un écran intermédiaire formant pochoir réalisé conformément aux enseignements de l'invention, ainsi qu'une bande de métal 16 sur la face supérieure 18 de laquelle on désire effectuer un dépôt ou placage 20 par voie électrolytique.

A titre d'exemple, et pour simplifier la représentation et les explications, la bande de métal 16 est une bande pleine sur laquelle on désire effectuer un dépôt qui se présente sous la forme d'une bande ou d'une ligne étroite 20 illustrée en silhouette à la figure 1.

Dans le cadre de la mise en oeuvre industrielle du dispositif selon l'invention, la bande 16 peut bien entendu être une bande de composants fabriqués en série et en bande tels que des lames de contact pour connecteurs électriques ou des microcircuits électroniques

Selon une technologie connue, si la bande 16 n'est pas pleine, on peut prévoir (si le procédé et l'appareil général de conception connue d'électrodéposition le nécessitent) d'agencer une bande inférieure porteuse pleine ou étanche (non représentée) sous la bande 16.

La tresse supérieure 10, qui est par exemple réalisée en matériau synthétique, comporte dans sa partie longitudinale centrale des ajours 22 pour le passage et l'agitation de l'électrolyte, le nombre, le contour et les dimensions des ajours ou perforations 22 étant déterminés en association avec la conception de l'appareil pour la mise en oeuvre du dispositif selon l'invention

Les courroies de masquage 12 sont réalisées en matériau élastomère et elles sont ici au nombre dé deux agencés transversalement de part et d'autre en délimitant, par leurs bords longitudinaux internes et opposées 24 le contour ou tracé du dépôt que l'on souhaite réaliser sur la face supérieure 18 de la bande métallique 16.

Ainsi, dans le cas du dépôt sous la forme d'une ligne continue 20, les bords 24 des courroies de masquage 12 sont deux bords longitudinaux rectilignes et parallèles.

Les deux courroies latérales 12 sont fixées à la tresse 10, par exemple par collage, et elles déterminent ainsi avec une très grande précision la, ou les, zone(s) à revêtir, sans qu'il soit nécessaire de prévoir des moyens spécifiques de guidage et de réglage de la position relative latérale ou transversale de ces courroies 12, comme c'est le cas selon les enseignements de la technologie "MECO".

Conformément aux enseignements de l'invention, on prévoit, entre la face inférieure 26 des courroies de masquage 12 et la face supérieure 18 de la bande métallique 16 à revêtir, le pochoir intermediaire 14.

Selon une technique analogue à la série sérigraphie, le pochoir 14 est un réseau maillé dont les mailles délimitent des trous 28 permettant chacun le passage d'une quantité d'électrolyte de manière à obtenir la formation, sur la face supérieure 18, d'un revêtement métallique 30 dont la surface 32, ici la surface supérieure externe en considérant les figures, comporte un motif régulier de pics 34 en relief, correspondant au motif du réseau maillé 14.

De préférence, l'écran intermédiaire 14 formant pochoir et les courroies de masquage 12 forment un ensemble unitaire, l'écran 14 étant par exemple collé aux courroies 12 pour un défilement.

A titre d'exemple non limitatif, le pochoir 14 peut être une structure tissée, ou analogue à une structure tissée, dont les fils de trame et de chaîne sont disposés selon un pas de 300 fils par pouce (2,54 mm) aboutissant à une section de passage pour chaque trou de l'ordre de 25.10⁻⁴ mm².

L'épaisseur moyenne E1 du revêtement 30 déposé sur la face supérieure 18 est comprise entre 60 et 70 % de l'épaisseur maximale E2 du revêtement correspondant à la valeur de crête des pics 34.

On réalise ainsi une économie importante de matière pour un dépôt 30 dont l'épaisseur maximale E2 est égale à l'épaisseur maximale d'un dépôt selon l'état de la technique dans lequel la surface supérieure 32 du dépôt ne comporte pas de pics au sens de l'invention, mais est une surface "lisse" à l'échelle macroscopique ou microscopique.

En fonction des dimensions des mailles du pochoir 14 et des différents réglages de l'installation, ainsi qu'en fonction de la nature de l'électrolyte et du métal déposé, on obtient la formation des pics 34 dont chacun est sensiblement en forme de trièdre ou de tronc de pyramide avec les sommets des pics qui sont tous sensiblement coplanaires.

## Revendications

1. Dispositif pour le dépôt, ou placage, en continu par voie électrolytique d'une couche (30) de revêtement métallique, notamment en métal précieux, selon un tracé déterminé (20) sur la face supérieure (18) d'une bande métallique (16), du type comportant au moins un masque supérieur interposé entre l'électrolyte et la face supérieure (18) de la bande métallique (16) et qui est réalisé sous la forme d'au moins une courroie latérale (12) de masquage qui défile en continu avec la bande métallique (16) et dont les découpes (24) correspondent au tracé (20) à réaliser, **caractérisé en ce qu'**il comporte un écran intermédiaire (14), formant pochoir, qui est interposé entre le masque (12) et la face supérieure (18) de la bande métallique (16), qui défile en continu avec la bande métallique (16) et qui est constitué d'un réseau maillé délimitant des trous pour le passage de l'électrolyte de manière à obtenir le dépôt d'un revêtement (30) comportant en surface (32) une série de pics (34) agencés selon le motif des mailles du pochoir (14).

2. Dispositif selon la revendication 1, **caractérisé en ce que** la face inférieure de l'écran intermédiaire (14) est en contact avec la face supérieure (18) de la bande métallique (16).

3. Dispositif selon l'une quelconque des revendications précédentes, **caractérisé en ce que** l'écran intermédiaire (14) est réalisé sous la forme d'un ruban.

4. Dispositif selon la revendication précédente, **caractérisé en ce que** le ruban formant écran intermédiaire (14) est lié en défilement avec la courroie de masquage (12), notamment par collage.

5. Dispositif selon l'une quelconque des revendications précédentes, **caractérisé en ce que** l'écran intermédiaire (14) est réalisé par tissage.

6. Dispositif selon l'une quelconque des revendications précédentes, **caractérisé en ce que** le motif des mailles (28) du pochoir (14) est un motif à mailles carrées.

7. Dispositif selon la revendication précédente, **caractérisé en ce que** la section de passage du trou de chaque maille (28) est égale à environ 25.10⁻⁴ mm², avec un pas de maillage d'environ 8,5.10⁻² mm

8. Dispositif selon l'une quelconque des revendications précédentes, **caractérisé en ce que** le masque supérieur est constitué d'au moins une courroie latérale de masquage qui est fixée, et liée en défilement continu, sous la face inférieure d'un support supérieur (10) réalisée notamment sous la forme d'une tresse comportant des ajours (22).

9. Composant électrique ou électronique fabriqué en bande et du type comportant une portion de face supérieure (16) munie d'une couche (30) de revêtement métallique déposée en continu par voie électrolytique, selon un tracé déterminé (20), **caractérisé en ce que**, en surface, la couche de revêtement métallique (30) comporte une série de pics (34) agencés selon un motif maillé, **en ce que** les sommets des pics (34) sont sensiblement coplanaires, et **en ce que** chaque pic (34) est sensiblement en forme de tronc de pyramide.

10. Composant selon la revendication 9, **caractérisé en ce que** l'épaisseur moyenne (E1) de la couche de revêtement métallique (30) est comprise entre 60 et 70% de son épaisseur maximale (E2) mesurée à la crête des pics (34).

11. Composant selon l'une des revendications 9 ou 10, **caractérisé en ce que** l'épaisseur maximale (E2) de la couche de revêtement métallique mesurée à la crête des pics (34) est comprise entre 0,2 et 2 micromètres, notamment entre 1,4 et 2 micromètres.

## Patentansprüche

1. Vorrichtung zur kontinuierlichen Aufbringung einer Schicht (30) aus einem metallischen Überzug auf elektrolytischem Weg, insbesondere aus Edelmetall, entlang einem vorgegebenen Verlauf (20) auf der Oberseite (18) einer Metallplatte (16), die mindestens eine obere Maske oder Abdeckung besitzt, die sich zwischen dem Elektrolyt und der Oberseite (18) der Metallplatte (16) befindet, und die in Form eines seitlichen Abdeckungsriemens (12) hergestellt ist, der kontinuierlich mit der Metallplatte (16) verläuft, dessen Anschnitte (24) der herzustellenden Linie (20) entsprechen, **dadurch gekennzeichnet, dass** sie eine Zwischenabschirmung (14) besitzt, die eine Schablone bildet, und die zwischen der Maske oder Abdeckung (12) und der Oberseite (18) der Metallplatte (16) eingeschoben ist, und mit der Metallplatte (16) kontinuierlich verläuft, und aus einem Maschennetz besteht, das Löcher für den Durchgang des Elektrolyten begrenzt, so dass ein Überzug (30) aufgebracht wird, der auf seiner Oberfläche (32) eine Reihe von Zacken (34) aufweist, die nach dem Muster von Maschen oder Gitterzellen der Schablone (14) angeordnet sind.

2. Vorrichtung nach Anspruch 1, **dadurch gekennzeichnet, dass** die Unterseite der Zwischenabschirmung (14) mit der Oberseite (18) der Metallplatte (16) in Berührung steht.

3. Vorrichtung nach einem der vorhergehenden Ansprüche, **dadurch gekennzeichnet, dass** die Zwischenabschirmung (14) in Form eines Bandes hergestellt ist.

4. Vorrichtung nach dem vorhergehenden Anspruch, **dadurch gekennzeichnet, dass** das Band, welches die Zwischenabschirmung (14) bildet, durchlaufend mit dem Abdeckungsriemen (12) verbunden ist, und zwar insbesondere durch Verkleben.

5. Vorrichtung nach einem der vorhergehenden Ansprüche, **dadurch gekennzeichnet, dass** die Zwischenabschirmung (14) durch Weben hergestellt ist.

6. Vorrichtung nach einem der vorhergehenden Ansprüche, **dadurch gekennzeichnet, dass** es sich bei dem Muster der Maschen bzw. Gitterzellen (28) der Schablone (14) um quadratische Zellen bzw. Maschen handelt.

7. Vorrichtung nach dem vorhergehenden Anspruch, **dadurch gekennzeichnet, dass** der Durchgangsquerschnitt des Loches jeder Masche bzw. Gitterzelle (28) ungefähr 25.10⁻⁴ mm² entspricht und der Maschenabstand ungefähr 8,5.10⁻² mm beträgt.

8. Vorrichtung nach einem der vorhergehenden Ansprüche, **dadurch gekennzeichnet, dass** die obere Maske bzw. Abdeckung aus mindestens einem seitlichen Abdeckungsriemen besteht, der unter der Unterseite einer oberen Auflage (10) befestigt und kontinuierlich damit verbunden ist, wobei die Auflage insbesondere aus einem Geflecht mit Öffnungen (22) hergestellt ist.

9. Elektrisches oder elektronisches Bauelement in Streifenform mit einem Teil einer Oberseite (16), die mit einer Schicht (30) aus einem Metallüberzug versehen ist, welche kontinuierlich entsprechend einem vorgegebenen Verlauf (20) auf elektrolytischem Wege aufgebracht wurde, **dadurch gekennzeichnet, dass** die Schicht des metallischen Überzugs (30) an ihrer Oberfläche eine Reihe von Zacken (34) aufweist, die nach einem Muster von Maschen bzw. Gitterzellen angeordnet sind, dass die Spitzen der Zacken (34) im wesentlichen komplanar sind und dass jede Zacke (34) im wesentlichen die Form eines Pyramidenstumpfes besitzt.

10. Elektrisches oder elektronisches Bauelement nach Anspruch 9, **dadurch gekennzeichnet, dass** die durchschnittliche Stärke (E1) der Schicht des Metallüberzugs zwischen 50 und 70 % ihrer maximalen Stärke (E2) liegt, die an dem Kamm der Zacken (34) gemessen wird.

11. Bauelement nach einem der vorhergehenden Ansprüche 9 oder 10, **dadurch gekennzeichnet, dass** die maximale Stärke (E2) der Schicht des Metallüberzugs, die an dem Kamm der Zacken (34) gemessen wird, zwischen 0,2 und 2 Mikrometer und insbesondere zwischen 1,4 und 2 Mikrometer liegt.

## Claims

1. Device for the continuous electrolytic deposition of, or plating with, a metal coating layer (30), especially made of a precious metal, as a defined stripe (20) on the upper face (18) of a metal strip (16), of the type comprising at least one upper mask which is interposed between the electrolyte and the upper face (18) of the metal strip (16) and is made in the form of at least one lateral masking belt (12) that runs continuously with the metal strip (16) and the cut edges (24) of which correspond to the stripe (20) to be produced, **characterized in that** it includes an intermediate screen (14), forming a stencil, which is interposed between the mask (12) and the upper face (18) of the metal strip (16), which runs continuously with the metal strip (16) and consists of a meshed network defining holes for passage of the electrolyte so as to deposit a coating (30) having on its surface (32) a series of peaks (34) arranged in the pattern of the meshes of the stencil (14).

2. Device according to Claim 1, **characterized in that** the lower face of the intermediate screen (14) is in contact with the upper face (18) of the metal strip (16).

3. Device according to either of the preceding claims, **characterized in that** the intermediate screen (14) is made in the form of a tape.

4. Device according to the preceding claim, **characterized in that** the tape forming the intermediate screen (14) is bonded, especially by adhesive bonding, to the masking belt (12) so as to run with the latter.

5. Device according to any one of the preceding claims, **characterized in that** the intermediate screen (14) is produced by weaving.

6. Device according to any one of the preceding claims, **characterized in that** the pattern of the meshes (28) of the stencil (14) is a pattern with square meshes.

7. Device according to the preceding claim, **characterized in that** the flow area of the hole of each mesh (28) is approximately equal to 25 × 10⁻⁴ mm², with a mesh pitch of approximately 8.5 × 10⁻² mm.

8. Device according to any one of the preceding claims, **characterized in that** the upper mask consists of at least one lateral masking belt which is fastened to, and bonded so as to run continuously with, the lower face of an upper support (10) produced especially in the form of a braid having apertures (22).

9. Electrical or electronic component manufactured in strip form and of the type comprising an upper face portion (16) provided with a metal coating layer (30) continuously deposited electrolytically as a defined stripe (20), **characterized in that** the metal coating layer (30) has, on its surface, a series of peaks (34) arranged in a meshed pattern, **in that** the tops of the peaks (34) are substantially coplanar, and **in that** each peak (34) is substantially in the form of a truncated pyramid.

10. Component according to Claim 9, **characterized in that** the mean thickness (E1) of the metal coating layer (30) is between 60 and 70% of its maximum thickness (E2) measured to the top of the peaks (34).

11. Component according to any one of Claims 9 or 10, **characterized in that** the maximum thickness (E2) of the metal coating layer measured to the top of the peaks (34) is between 0.2 and 2 microns, especially between 1.4 and 2 microns.
